# EUROPÄISCHE PATENTSCHRIFT

(11) **EP 3 205 583 B1**
(45) Veröffentlichungstag und Bekanntmachung des Hinweises auf die Patenterteilung: **16.01.2019**
(21) Anmeldenummer: 17152191.7
(22) Anmeldetag: 19.01.2017
(51) Int. Cl.: B64D 47/06, B64C 27/46, B64D 41/00, H01L 41/113, H02N 2/18

(54) **ELEKTRISCHES ENERGIEERZEUGUNGSSYSTEM FÜR EIN ROTORBLATT, BELEUCHTUNGSSYSTEM FÜR EIN ROTORBLATT, ROTORBLATT SOWIE ROTORSYSTEM**
ELECTRICAL ENERGY GENERATING SYSTEM FOR A ROTOR BLADE, ILLUMINATION SYSTEM FOR A ROTOR BLADE, ROTOR BLADE AND ROTOR SYSTEM
SYSTÈME DE PRODUCTION D'ÉLECTRICITÉ POUR UNE PALE DE ROTOR, SYSTÈME D'ÉCLAIRAGE POUR UNE PALE DE ROTOR, PALE DE ROTOR ET SYSTÈME DE ROTOR

(30) Priorität: 11.02.2016 DE 102016202066; 14.11.2016 DE 102016222265
(43) Veröffentlichungstag der Anmeldung: 16.08.2017
(73) Patentinhaber: Airbus Defence and Space GmbH, 82024 Taufkirchen (DE)
(72) Erfinder: SEBALD, Johannes, 27721 Ritterhude (DE); BECKER, Thomas, 27711 Osterholz-Scharmbeck (DE)
(74) Vertreter: Isarpatent

(56) Entgegenhaltungen:
- EP-A1- 2 849 334
- WO-A1-2008/111932
- DE-U1-202008 008 517
- KR-A- 20130 112 661
- US-A- 5 500 635
- US-A1- 2004 075 363
- US-A1- 2005 274 176
- US-A1- 2014 170 919
- US-B1- 6 437 422

## Beschreibung

Die Erfindung betrifft ein Rotorblatt mit einem elektrischen Energieerzeugungssystem sowie ein Rotorsystem.

Moderne Helikopter weisen eine Vielzahl von elektrisch betriebenen Komponenten auf, wie beispielsweise Beleuchtungseinrichtungen, Sensoren, Steuerungseinrichtungen oder dergleichen. Üblicherweise werden auch in mit elektrischen Versorgungsleitungen schlecht erreichbaren Bereichen des Helikopters elektrische Komponenten benötigt. Insbesondere werden auch an rotierenden Bauteilen, wie z.B. dem Rotor oder Rotorblättern benötigt. Da von den sich drehenden Rotorblättern erhebliche Gefahren ausgehen sind aus dem Stand der Technik Vorrichtungen bekannt, mittels derer die äußere Begrenzung von sich drehenden Rotorblättern optisch angezeigt und damit erkennbar gemacht werden können.

Aus der WO 2008/111932 A1 ist beispielsweise eine autonome Blattspitzenbeleuchtung für Rotorblätter bekannt, bei der die Beleuchtung mittels Leuchtdioden erfolgt und bei der die zur Versorgung der Leuchtdiode benötigte elektrische Energie piezoelektrisch zur Verfügung gestellt wird. Für die piezoelektrische Stromerzeugung wird die Bewegung der Rotorblätter genutzt, indem die Vibrationen der Rotorblätter piezoelektrisch in Strom umgewandelt werden.

Auch aus der DE 20 2008 008 517 U1 ist ein energieautarkes Beleuchtungssystem für Rotorblattspitzen bekannt, bei dem die für die Versorgung der Lichtquelle benötigte elektrische Energie durch eine im Rotorblatt angeordnete Energieversorgungseinheit bereitgestellt wird, die im Betrieb des Rotorblatts elektrischen Strom aus dessen Vibrationen erzeugt.

Die US 6,437,422 B1 beschreibt ein aktives Bauelement in Form eines Fadens. Der Faden weist einen Kern aus einem piezoelektrischen Material auf, welcher von einem Halbleitermantel umgeben ist. An der Außenoberfläche des Halbleitermantels sind Elektroden angeordnet, an denen eine infolge der Verformung des Kerns erzeugte elektrische Spannung abgegriffen werden kann
Es ist eine der Aufgaben der vorliegenden Erfindung, ein elektrisches Energieerzeugungssystem für ein Rotorblatt bereitzustellen, das eine zuverlässige und leistungsstarke Energieversorgung von elektrisch betreibbaren Funktionskomponenten gewährleistet.
Diese Aufgabe wird durch die Gegenstände der unabhängigen Ansprüche gelöst. Vorteilhafte Ausgestaltungen und Weiterbildungen ergeben sich aus den auf die unabhängigen Ansprüche rückbezogenen Unteransprüchen in Verbindung mit der Beschreibung.
Gemäß einem ersten Aspekt der vorliegenden Erfindung ist ein Rotorblatt mit einem elektrischen Energieerzeugungssystem vorgesehen. Dieses weist zumindest eine elektromechanische Energiewandlungsvorrichtung und zumindest einen Kraftleitfaden auf, der mit der elektromechanischen Energiewandlungsvorrichtung mechanisch verbunden ist und zumindest abschnittsweise außerhalb des Rotorblatts verläuft. Die elektromechanische Energiewandlungsvorrichtung ist derart gestaltet, dass diese bei einer Bewegung des Kraftleitfadens die durch die Bewegung des Kraftleitfadens in die elektromechanische Energiewandlungsvorrichtung eingeleiteten Kräfte in elektrische Energie umwandelt.
Das elektrische Energieerzeugungssystem weist demnach eine oder mehrere Vorrichtungen zum Bereitstellen elektrischer Energie in Form elektromechanischer Energiewandlungsvorrichtungen auf. Jeweils einer Energiewandlungsvorrichtung ist ein oder sind mehrere Kraftleitfäden zugeordnet. Die Kraftleitungsfäden oder Bewegungsbänder sind kinematisch an die Energiewandungsvorrichtung gekoppelt. Bei einer Beaufschlagung des zumindest einen Kraftleitfadens mit einer Kraft, beispielsweise infolge der Bewegung des Rotorblatts, wird diese Kraft mittels des Kraftleitfadens oder Kraftleitbandes in die Energiewandlungsvorrichtung eingeleitet. Die auf diese Weise der Energiewandlungsvorrichtung zugeführte mechanische Energie wandelt die Energiewandlungsvorrichtung in elektrische Energie um.

Durch die Bewegung des Kraftleitfadens werden auf die elektrische Energiewandungsvorrichtung insbesondere Zugkräfte ausgeübt, wobei auch Querkräfte aus der Bewegung des Kraftleitfadens auf die elektrische Energiewandungsvorrichtung übertragen werden können. Die Bewegung des Kraftleitfadens kann dabei einerseits durch die vom Rotorblatt auf den Kraftleitfaden ausgeübten Kräfte, beispielsweise aufgrund der Trägheit des Kraftleitfadens und aufgrund von Rotationen des Rotorblatts, oder aber insbesondere durch auf den Kraftleitfaden wirkende Luftkräfte hervorgerufen werden, wobei in der Regel verschiedene Kräfte auf den Kraftleitfaden wirken. Hierbei bietet der Kraftleitfaden den Vorteil, dass dieser starke Zugkräfte aufnehmen kann und damit eine effiziente Energiewandlung gewährleistet.

Bei der erfindungsgemäßen Lösung können auf die elektromechanische Energiewandlungsvorrichtung durch den mittels der Rotorblattbewegung angeregten Kraftleitfaden größere Kräfte ausgeübt werden als durch die Vibrationen des Rotorblatts allein, so dass mehr Energie gewandelt werden kann. Dadurch kann entweder die Zahl der elektromechanischen Energiewandlungsvorrichtung je Rotorblatt verringert werden, oder es können mehr bzw. lichtstärkere elektrische Funktionskomponenten eingesetzt werden.

Gemäß einer vorteilhaften Weiterbildung kann der wenigstens eine Kraftleitfaden insbesondere direkt mit der elektromechanischen Energiewandlungsvorrichtung verbunden sein. Hierzu kann beispielsweise vorgesehen sein, dass der Kraftleitfaden zwischen einem ersten von elektromechanischen Energiewandlungsvorrichtung abgewandten Ende und einem mechanisch mit der elektrischen Energiewandungsvorrichtung verbundenen zweiten Ende ununterbrochen verläuft. Dadurch wird ein einfacher Aufbau des Energiewandlungssystems gewährleistet.
Alternativ hierzu kann vorgesehen sein, dass eine elektrische Funktionskomponente mechanisch zwischen zwei Fadenabschnitten, z.B. zwischen dem ersten und dem zweiten Ende des Kraftleitfadens oder zwischen einem der Enden des Kraftleitfadens und der elektromechanischen Energiewandlungsvorrichtung anordenbar ist, so dass die elektrische Funktionskomponente im Kraftfluss selbst angeordnet werden kann. Auf diese Weise wird ein geringer Bauraumbedarf gewährleistet. Insbesondere kann auf elektrische Versorgungsleitungen verzichtet werden, wodurch außerdem ein Gewichtsvorteil erzielt wird.
Weiterhin kann vorgesehen sein, dass jeweils das erste und das zweite Ende des Kraftleitfadens direkt mit der elektromechanischen Energiewandlungsvorrichtung verbunden sind. Hierbei bildet der Kraftleitfanden eine Schlaufe. Es wird durch diese Schlaufe ein relativ hoher Luftwiderstand und damit eine große Zugkraft auf den Kraftleitfaden bewirkt. Dadurch wird die Leistung des Energieerzeugungssystems verbessert. Der Kraftleitfaden bzw. das Kraftleitband kann insbesondere aus einem Kunststoffmaterial, beispielsweise aus einem Polymermaterial, gebildet sein. Kunststoffmaterialien, insbesondere Polymere, sind in zahlreichen Varianten und mit hoher mechanischer Festigkeit verfügbar. Ein weiterer Vorteil von Kunststoffmaterialien, insbesondere Polymeren, liegt darin dass diese mit verschiedenen Lichtbrechungsindizes herstellbar sind. Dadurch kann der Kraftleitfaden vorteilhaft und in einfacher Weise als lichtleitende Faser ausgebildet werden. Weiterhin lassen sich auch in eine Kunststoffmatrix eingebettete Nanoröhrchen vorteilhaft als Material für das Kraftleitband verwenden. Auch können Geflechte aus einem Metallmaterial als Kraftleitfäden verwendet werden. Diese sind insbesondere kostengünstig herstellbar und weisen eine hohe mechanische Stabilität auf.

In einer besonders vorteilhaften Ausgestaltung kann vorgesehen sein, dass die elektromechanische Energiewandlungsvorrichtung zumindest ein mechanisch mit dem Kraftleitfaden verbundenes Piezoelement zur Umwandlung mechanischer Energie aus der Bewegung des Kraftleitfadens in elektrische Energie aufweist. Die elektromechanische Energiewandlungsvorrichtung wandelt die mechanische Energie aus der Bewegung des Kraftleitfadens somit durch die Wirkung von einem oder mehreren Piezoelementen in elektrische Energie um. Diese Piezoelemente setzen die durch den Kraftleitfaden auf die Energiewandlungsvorrichtung ausgeübten mechanischen Wechselkräfte in elektrische Energie um. Diese elektrische Energie kann vorteilhaft zur Versorgung der elektrisch betreibbaren Funktionskomponenten, beispielsweise in Form von Lichtquellen, genutzt werden. Beispielsweise kann je Kraftleitfaden ein Piezoelement vorgesehen sein. Es ist aber auch denkbar, nur ein Piezoelement für mehrere Kraftleitfäden vorzusehen.

Dabei kann der Kraftleitfaden unmittelbar oder über weitere Verbindungselemente an dem jeweiligen Piezoelement befestigt sein.

Gemäß einer weiteren vorteilhaften Ausgestaltung kann vorgesehen sein, dass der Kraftleitfaden zumindest abschnittsweise von einem piezoelektrischen Material des Piezoelements umgeben ist. Dadurch wird eine besonders hohe Umwandlungseffizienz der mechanischen Bewegung des Kraftleitfadens in elektrische Energie erzielt.

Gemäß dieser Ausgestaltung können die Piezoelemente insbesondere derart gestaltet sein, dass diese den Kraftleitfaden in Bezug auf dessen Längserstreckung zumindest abschnittsweise umhüllen. Die Kräfte aus der Bewegung des Kraftleitfadens werden dann in das umhüllende Piezoelement beispielsweise flächig dort eingeleitet, wo der Kraftleitfaden mit dem umhüllenden Piezoelement verbunden ist. Hierfür können beispielsweise PVDF-Nanokomposite, also Polyvinylidenflourid-Nanokomposite verwendet werden. Weiterhin kann auch zumindest ein Endabschnitt des Kraftleitfadens in das piezoelektrische Material eingebettet bzw. von diesem aufgenommen sein.

Als piezeoelektrisches Material können für sämtliche Ausführungsformen insbesondere sogenannte "conformable piezoelectric polymers", wie Polyvinylidenflourid (PVDF), Poly(Vinylidenfluorid-co-trifluoroethylen) (P(VDF-TrFE)) oder Materialien auf sogenannter Carbon-Nanotube-Basis (CNT Basis) verwendet werden.

Gemäß einer weiteren vorteilhaften Ausführungsform weist das elektrische Energieerzeugungssystem zumindest einen elektrisch mit der elektromechanischen Energiewandlungsvorrichtung verbundenen Energiespeicher zum Speichern elektrischer Energie auf. Dadurch kann die bei Bewegung des Rotorblatts gewandelte Energie zwischengespeichert werden, um eine elektrisch betreibbare Funktionskomponente auch bei geringerer Drehzahl der Rotorblätter, oder vorübergehend auch bei Stillstand des Rotors mit elektrischer Energie zu versorgen.

Der Energiespeicher kann insbesondere als ein Kondensator, als ein Akkumulator oder als ein ähnlicher Speicher für elektrische Energie ausgebildet sein.

Nach einer weiteren vorteilhaften Weiterbildung der Erfindung weist das elektrische Energieerzeugungssystem zusätzlich eine elektronische Steuerungseinrichtung auf, mittels derer eine Bereitstellung von mittels der elektromechanischen Energiewandlungsvorrichtung erzeugter elektrischer Spannung an zum Anschluss elektrischer Funktionskomponenten vorgesehenen elektrischen Anschlussstellen des Energieerzeugungssystems ein- oder ausschaltbar ist. Das elektrische Energieerzeugungssystem weist demnach eine Elektronik auf, mittels derer an das System anschließbare elektrische Funktionskomponenten ein- oder ausgeschaltet werden können. Dadurch werden die Einsatzmöglichkeiten der Funktionskomponenten verbessert.

Bevorzugt ist vorgesehen, dass die Steuerungseinrichtung drahtlos ansteuerbar ist. Beispielsweise kann die Steuerungseinrichtung durch Funksignale ansteuerbar ausgeführt sein. Es sind jedoch auch andere Möglichkeiten zum Ansteuern denkbar, beispielsweise optische Signale oder akustische Signale. Weiterhin kann die Steuerungseinrichtung Helligkeitssensoren oder dergleichen aufweisen, welche bei einer bestimmten Helligkeit die Bereitstellung von elektrischer Spannung an- bzw. abschalten. Durch die drahtlose Ansteuerbarkeit kann das elektrische Energieerzeugungssystem vorteilhaft ohne Steuerleitungen gesteuert und betrieben werden.

Optional weist das Rotorblatt ein Beleuchtungssystem auf. Das Beleuchtungssystem weist wenigstens eine elektrischen Lichtquelle auf, die mit der Energiewandlungsvorrichtung des elektrischen Energieerzeugungssystems elektrisch verbunden ist. Die durch das Energieerzeugungssystem erzeugbare elektrische Energie wird demnach vorteilhaft zum Betreiben einer elektrischen Lichtquelle genutzt. Aufgrund der hohen Effizienz der Energiewandlung des Energieerzeugungssystems wird der Einsatz von leistungsstarken Lichtquellen ermöglicht.

Gemäß einer bevorzugten Ausführungsform des Beleuchtungssystems ist der Kraftleitfaden des Energieerzeugungssystems als lichtleitende Faser ausgebildet und der Kraftleitfaden mit der Lichtquelle mechanisch derart verbunden, dass die Lichtquelle Licht in den Kraftleitfaden einleitet, und die Lichtquelle ist mit der elektromechanischen Energiewandlungsvorrichtung mechanisch derart verbunden, dass die durch die Bewegung des Kraftleitfadens erzeugten Kräfte über die Lichtquelle zu der elektromechanischen Energiewandlungsvorrichtung übertragen werden. Das von der Lichtquelle erzeugte Licht wird demnach durch den als Lichtleitfaser ausgebildeten Kraftleitfaden hindurch von einem ersten Fadenende zu einem entgegengesetzt zu diesem gelegenen zweiten Fadenende übertragen. Das erste Fadenende ist hierbei das an der Lichtquelle gelegene Ende des Kraftleitfadens, das zweite Fadenende das der Lichtquelle bzw. elektromechanischen Energiewandlungsvorrichtung abgewandt gelegene Ende. Die Lichtquelle ist ferner mit der elektromechanischen Energiewandlungsvorrichtung mechanisch verbunden. Die aufgrund der Bewegung des Kraftleitfadens, der beispielsweise infolge der Bewegung eines Rotorblatts bewirkt wird, erzeugten Kräfte werden dabei über die Lichtquelle, die mechanisch im Kraftfluss angeordnet ist, zu der Vorrichtung zum Bereitstellen elektrische Energie übertragen, welche die mechanische Energie in elektrische Energie wandelt.

Bei dieser besonders vorteilhaften Ausgestaltung dient der Kraftleitfaden somit einerseits zum Erzeugen von Kräften für die elektromechanische Energiewandlungsvorrichtung und andererseits auch zur Übertragung des durch die Lichtquelle erzeugten Lichts. Dadurch kann die Lichtquelle auch innerhalb des Rotorblatts, beispielsweise in unmittelbarer Nähe oder direkt an elektromechanischen Energiewandlungsvorrichtung angeordnet werden, und das Licht wird durch den als lichtleitende Faser ausgebildeten Kraftleitfaden zum Rotorblattäußeren übertragen. Beispielsweise kann der Kraftleitfaden eine Länge aufweisen, bei der das zweite Fadenende außerhalb eines Rotorblatts positioniert ist, sodass der Kraftleitfaden sich teilweise außerhalb des Rotorblatts bewegen kann. Dadurch wird eine gut erkennbare Beleuchtung des Rotorblatts gewährleistet. Durch die Nutzung des oben beschriebenen Energiewandlungssystems können besonders leuchtstarke Lichtquellen verwendet werden.

Bevorzugt weist die wenigstens eine Lichtquelle jeweils zumindest eine Leuchtdiode auf. Mit Leuchtdioden kann bei geringem Energieverbrauch eine große Lichtausbeute erzielt und das Licht gegebenenfalls gut in eine lichtleitende Faser eingekoppelt werden. Darüber hinaus sind Leuchtdioden mechanisch robust, z.B. gegenüber den Vibrationen und Beschleunigungen bei der Anordnung an einem Rotorblatt. Auch sind Leuchtdioden vorteilhaft zur mechanischen Übertragung von Kräften geeignet, beispielsweise wenn sie zwischen einem Fadenende eines als lichtleitende Faser ausgebildeten Kraftleitfadens und der elektromechanischen Energiewandlungsvorrichtung angeordnet sind. Jedoch können auch andere für den Einsatzzweck geeignete Lichtquellen verwendet werden.
Nach einer weiteren vorteilhaften Weiterbildung des Beleuchtungssystems ist die Lichtquelle im Inneren eines Rotorblatts anordenbar. Die Lichtquelle ist demnach insbesondere zur Anordnung innerhalb des Querschnitts des Rotorblatts vorgesehen. Auf diese Weise wird eine Beleuchtung ohne aerodynamisch ungünstige Anbauten an der Außenfläche des Rotorblatts realisiert.
Insbesondere kann die Lichtquelle zur Anordnung in einer Tiefenwuchtkammer des Rotorblatts vorgesehen sein. Dies bietet den Vorteil, dass ein innerhalb des Querschnitts gelegener Bauraum effizient ausgenutzt wird. Dadurch ergibt sich ein kompakter Aufbau des Beleuchtungssystems und eine konstruktive Umgestaltung des Rotorblatts kann weitgehend vermieden werden.

Das Rotorblatt ist für ein Luftfahrzeug vorgesehen sein. Das Rotorblatt weist das elektrische Energieerzeugungssystem nach einer der voranstehend beschriebenen Ausführungsformen auf. Das elektrische Energieerzeugungssystem bildet somit eine lokal an dem Rotorblatt vorgesehene elektrische Energiequelle. Hierbei werden durch eine Rotation des Rotorblatts hervorgerufene Vibrationen aufgrund des Kraftleitfadens des elektrischen Energieerzeugungssystems in besonders effizienter Weise in elektrische Energie umgesetzt. Der Kraftleitfaden bildet dabei insbesondere eine Art Hebel welcher die auf die elektromechanische Energiewandlungsvorrichtung wirkende Kraft vergrößert.

Erfindungsgemäß ist vorgesehen, dass der wenigstens eine Kraftleitfaden zumindest abschnittsweise außerhalb eines Rotorblatts, insbesondere außerhalb eines Querschnitts des Rotorblatts, verläuft. Hierbei erstreckt sich der Kraftleitfaden zumindest teilweise in einem eine Außenkontur des Rotorblatts umgebenden Fluid. Bei einer Bewegung des Rotorblatts wird dadurch in besonders effizienter Weise eine Kraft auf den Kraftleitfaden ausgeübt, insbesondere eine Zugkraft. Die durch diese Kraft in die elektromechanische Energiewandlungsvorrichtung eingeleitete Energie wird dann durch diese in elektrische Energie umgewandelt.

Beispielsweise kann vorgesehen sein, dass der Kraftleitfaden mit einem Endabschnitt, beispielsweise dem von der elektromechanischen Energiewandlungsvorrichtung abgewandt gelegenen zweiten Fadenende, aus dem Querschnitt des Rotorblatts herausragt. Auch kann vorgesehen sein, dass ein zwischen dem ersten und dem zweiten Fadenende gelegener Mittelabschnitt außerhalb des Rotorblatts verläuft. Dadurch bildet der außerhalb des Rotorblatts verlaufende Abschnitt des Fadens einen Strömungswiderstand aus und zusätzlich zu den Trägheitskräften, die auch auf den im Rotorblatt angeordneten Fadenabschnitt wirken, wirken Luftkräfte aus der Bewegung des Rotorblatts auf den aus dem Rotorblatt ragenden Fadenabschnitt. Dadurch werden die auf den Kraftleitfaden wirkenden Kräfte vergrößert und es wird ein größerer Betrag an mechanischer Energie in die Vorrichtung zur Bereitstellung elektrischer Energie eingebracht und in elektrische Energie umgewandelt. Dadurch wird die Leistungsfähigkeit der Beleuchtungsvorrichtung verbessert.

Weiterhin ist denkbar, dass das Energieerzeugungssystem insgesamt an einer Außenfläche des Rotorblatts, beispielsweise an der Rotorblattspitze, angebracht ist.

Bevorzugt ist jedoch vorgesehen, dass die elektromechanische Energiewandlungsvorrichtung im Inneren des Rotorblatts, insbesondere in einer Tiefenwuchtkammer des Rotorblatts, angeordnet ist. Demnach ist vorgesehen, dass die elektromechanische Energiewandlungsvorrichtung im Inneren des Querschnitts des Rotorblatts angeordnet ist, wie zum Beispiel in einer Tiefenwuchtkammer des Rotorblatts. Dies bietet den Vorteil, dass der Einfluss des Energieerzeugungssystems auf die aerodynamischen Eigenschaften des Rotorblatts klein gehalten wird.
Allgemein können mehrere, vorzugsweise über die Längserstreckung des Rotorblatts verteilt angeordnete, elektrische Energieerzeugungssysteme vorgesehen sein. Diese können beispielsweise elektrisch parallel oder in Serie geschalten werden. Auf diese Weise lässt sich eine besonders leistungsstarke Energieversorgung für elektrisch betreibbare Funktionskomponenten erzielen.

Ein weiterer Aspekt der Erfindung betrifft ein Rotorsystem, für ein Luftfahrzeug, mit zumindest einem Rotorblatt gemäß einer der voranstehend beschriebenen Ausführungsformen und mit zumindest einer elektrisch betreibbaren Funktionskomponente, welche elektrisch mit der Energiewandlungsvorrichtung des elektrischen Energieerzeugungssystems verbunden ist. Mittels der Energiewandlungsvorrichtung wird die durch die Bewegung des Rotorblatts erzeugte Kraft auf den Kraftleitfaden effizient in elektrische Energie umgewandelt, welche zur Versorgung der elektrisch betreibbaren Funktionskomponenten genutzt wird.
Als elektrisch betreibbare Funktionskomponente kann insbesondere eine Lichtquelle, ein Sensor, eine Aktuatoreinrichtung oder dergleichen vorgesehen sein. Lichtquellen ermöglichen vorteilhaft eine Beleuchtung des Rotorblatts, insbesondere dessen Blattspitze, sodass ein bei der Bewegung des Rotorblatts überstrichener Gefahrenbereich optisch deutlich gekennzeichnet wird. Sensoren können vorteilhaft zur Erfassung aerodynamischer oder mechanischer Kenngrößen verwendet werden. Mittels Akutatoreinrichtungen können beispielsweise mechanische System an den Rotorblättern betätigt werden.

Das Rotorsystem kann als elektrisch betreibbare Funktionskomponente insbesondere eine Lichtquelle aufweisen. Gemäß einer derartigen vorteilhaften Weiterbildung des Rotorsystems weist dieses zumindest ein Rotorblatt, optional weitere Rotorkomponenten, wie beispielsweise einen Rotorschaft oder dergleichen, sowie eine Ausführungsform des oben beschriebenen Beleuchtungssystems auf. Hierbei können beispielsweise mehrere Lichtquellen vorgesehen sein, die vorzugsweise über die Zahl der Rotorblätter verteilt angeordnet sind. Beispielsweise können an jedem Rotorblatt eines Rotors eine oder mehrere Lichtquelle angeordnet sein. Dabei sind die Lichtquellen vorzugsweise an den Rotorblattspitzen oder in deren Nähe angeordnet. Die wenigstens eine Lichtquelle kann also allgemein in einem in Bezug auf die Längserstreckung des Rotorblatts axialen Endabschnitt desselben angeordnet sein. Die wenigstens eine elektrische Lichtquellen ist mit einer oder mehreren elektromechanischen Energiewandlungsvorrichtungen des elektrischen Energieerzeugungssystems elektrisch verbunden.

Im Folgenden wird die Erfindung unter Bezugnahme auf die Figuren der Zeichnungen erläutert. Von den Figuren zeigen:
- Fig. 1: eine schematische Ansicht eines Rotorsystems gemäß einem bevorzugten Ausführungsbeispiel der vorliegenden Erfindung;
- Fig. 2: eine schematische Ansicht eines Energieerzeugungssystems gemäß einem bevorzugten Ausführungsbeispiel der vorliegenden Erfindung;
- Fig. 3: eine schematische Ansicht eines Energieerzeugungssystems gemäß einem weiteren Ausführungsbeispiel der vorliegenden Erfindung;
- Fig. 4: eine schematische Ansicht eines Energieerzeugungssystems gemäß einem weiteren Ausführungsbeispiel der vorliegenden Erfindung; und
- Fig. 5: eine schematische Ansicht eines Rotorsystems gemäß einem weiteren Ausführungsbeispiel der vorliegenden Erfindung, bei dem ein Kraftleitfaden des Energieerzeugungssystems als Lichtleitfaser ausgebildet ist.

In den Figuren bezeichnen dieselben Bezugszeichen gleiche oder funktionsgleiche Komponenten, soweit nichts Gegenteiliges angegeben ist.

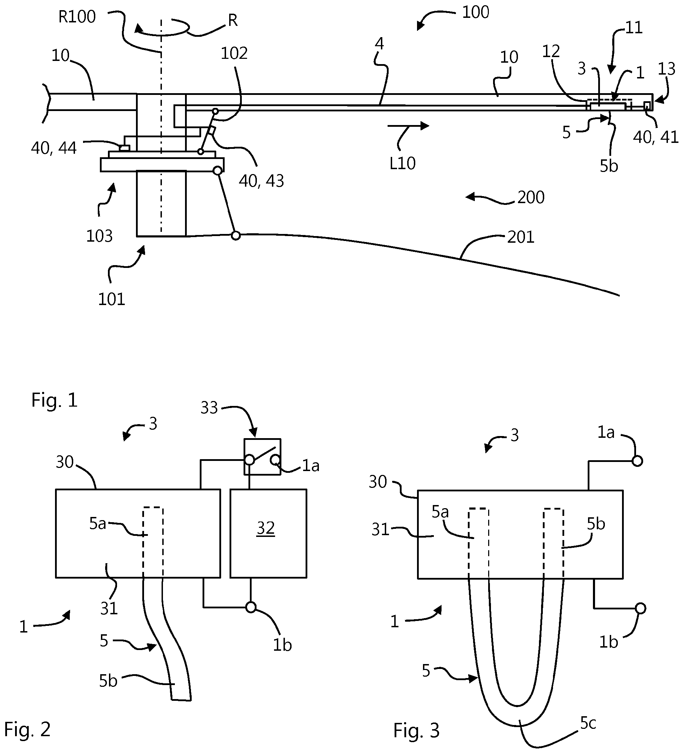

Fig. 1 zeigt beispielhaft ein Rotorsystem 100. Das Rotorsystem 100 weist zumindest ein Rotorblatt 10 mit einer elektrischen Energieerzeugungsvorrichtung 1 sowie eine elektrisch betreibbare Funktionskomponente 40 auf, welche elektrisch mit der elektrischen Energieerzeugungsvorrichtung 1 verbunden ist.

Das in Fig. 1 schematisch und beispielhaft gezeigte Rotorsystem 100 ist als Rotorsystem für ein Luftfahrzeug 200 dargestellt. Insbesondere weist das Rotorsystem 100 hierbei einen um eine Rotationsachse R100 drehbaren Rotorschaft 101 auf, welcher mit einer Rumpfstruktur 201 des Luftfahrzeugs 200 verbunden ist und welcher das zumindest eine Rotorblatt 10 sowie gegebenenfalls weitere Rotorblätter trägt.

Als elektrisch betreibbare Funktionskomponente 40 kann beispielsweise eine Lichtquelle 41, 42, ein Sensor 43, eine Aktuatoreinrichtung 44 oder dergleichen vorgesehen sein. In Fig. 1 sind beispielhaft eine an einer Rotorblattspitze 13 des Rotorblatts 10 angeordnete Lichtquelle 41, ein an einem Aktuatorstab 103 einer dem Rotorschaft 101 zugeordneten Taumelscheibe 102 angeordneter Sensor 43 sowie eine an der Taumelscheibe 102 angeordnete Aktuatoreinrichtung 44 dargestellt. Die Funktionskomponenten 40 sind jeweils über eine elektrische Versorgungsleitung 4 mit dem elektrischen Energieerzeugungssystem 1 des Rotorblatts 10 verbunden.
Wie in Fig. 1 gezeigt ist, weist das Rotorblatt 10 das elektrische Energieerzeugungssystem 1 auf. Bei dem in Fig. 1 beispielhaft gezeigten Rotorblatt 10 ist das Energieerzeugungssystem 1 in einem in Bezug auf die Längserstreckung oder Längsrichtung L10 des Rotorblatts 10 zu dem Rotorschaft 101 abgewandt gelegenen Endabschnitt 11 des Rotorblatts 10 angeordnet. Wie in Fig. 1 schematisch dargestellt ist, weist das Energieerzeugungssystem 1 zumindest eine elektromechanische Energiewandlungsvorrichtung 3 und zumindest einen Kraftleitfaden 5 auf. Der Kraftleitfaden 5 ist mit der elektromechanischen Energiewandlungsvorrichtung 3 mechanisch verbunden. Die elektromechanische Energiewandlungsvorrichtung 3 ist derart gestaltet, dass diese bei einer Bewegung des Kraftleitfadens 5 die durch die Bewegung des Kraftleitfadens 5 in die elektromechanische Energiewandlungsvorrichtung 3 eingeleiteten Kräfte in elektrische Energie umwandelt. Wie Fig. 1 schematisch zeigt, ist vorgesehen dass der wenigstens eine Kraftleitfaden 5 zumindest abschnittsweise außerhalb eines Rotorblatts 10 verläuft. Bei einer Rotation des Rotorblatts 10 um die Rotationsachse R100 wird der Kraftleitfaden 5 hinter dem Rotorblatt 10 hergezogen. Infolge der Umströmung des Rotorblatts 10 mit einem Fluid, bei einem Luftfahrzeug Luft, wird an dem Kraftleitfaden 5 eine Zugkraft erzeugt. Insbesondere wenn der Kraftleitfaden in ein Nachlaufgebiet des Rotorblatts 10 hineinragt, wird durch Verwirbelungen eine Art Flatterbewegung des Kraftleitfadens 5 bewirkt. Die mechanische Energie der Bewegung des Kraftleitfadens 5 wird durch die elektromechanische Energiewandlungsvorrichtung 3 in elektrische Energie umgewandelt.
Wie in Fig. 1 weiterhin gezeigt ist, ist die elektromechanische Energiewandlungsvorrichtung 3 vorzugsweise im Inneren des Rotorblatts 10 angeordnet. Fig. 1 zeigt beispielhaft eine Gestaltung des Rotorblatts 10, bei dem die elektromechanische Energiewandlungsvorrichtung 3 in einer Tiefenwuchtkammer 12 des Rotorblatts 10 angeordnet ist und ein Endabschnitt 5b des Kraftleitfadens 5 aus der Tiefenwuchtkammer 12 herausragt.

Die Fig. 2 bis 4 zeigen jeweils vorteilhafte Gestaltungen des elektrischen Energieerzeugungssystems 1. Bei den in den Fig. 2 bis 4 gezeigten Beispielen weist die elektromechanische Energiewandlungsvorrichtung 3 jeweils ein Piezoelement 30 auf, welches mechanisch mit dem Kraftleitfaden 5 gekoppelt ist. In den in den Fig. 2 bis 4 gezeigten Beispielen ist die mechanische Kopplung jeweils dadurch realisiert, dass der Kraftleitfaden zumindest abschnittsweise von einem das Piezoelement 30 bildenden piezoelektrischen Material 31 umgeben ist.

Bei dem in Fig. 2 gezeigten Energieerzeugungssystem 1 ist ein erster Endabschnitt 5a des Kraftleitfadens 5 in das piezoelektrische Material 31 eingebettet und ein in Bezug auf die Längserstreckung oder die Fadenlängsrichtung L5 des Kraftleitfadens 5 entgegengesetzt gelegener zweiter Endabschnitt 5b des Kraftleitfadens 5 ist frei bewegbar außerhalb des piezoelektrischen Materials 31 angeordnet. In Fig. 2 ist das Piezoelement 30 beispielhaft als Block dargestellt. An dem Piezoelement 30 sind Elektroden (nicht dargestellt) vorgesehen, an welchen die in Folge der durch den Kraftleitfaden 5 bewirkbaren Verformung erzeugbare Spannung abgreifbar ist. Hierzu sind Anschlussstellen 1a, 1b vorgesehen, welche in Fig. 2 schematisch gezeigt sind. Die Anschlussstellen sind zum Anschluss der elektrischen Funktionskomponenten 40 vorgesehenen. In Fig. 2 ist beispielhaft eine Konfiguration des Piezoelements 30 gezeigt, bei dem eine erste Anschlussstelle 1a einen elektrischen Pluspol bildet und eine zweite Anschlussstelle 1b einen elektrischen Minuspol.

Fig. 2 zeigt außerdem schematisch eine optionale elektronische Steuerungseinrichtung 33. Diese bildet in funktionaler Hinsicht einen Schalter, mittels derer die Bereitstellung von elektrischer Spannung an den elektrischen Anschlussstellen 1a 1b ein- oder ausschaltbar ist. Bevorzugt ist die Steuerungseinrichtung 33 drahtlos ansteuerbar. Gemäß der beispelhaften Darstellung der Fig. 2 ist die Steuerungseinrichtung 33 als ein der ersten Anschlussstelle 1a zugeordneter Schalter ausgeführt. Die Steuerungseinrichtung 33 kann beispielsweise über Funk angesteuert werden, um die elektrisch betreibbaren Funktionskomponenten 40 ein- oder auszuschalten.

Wie Fig. 2 weiterhin zeigt, kann das Energieerzeugungssystem 3 optional einen elektrisch mit der elektromechanischen Energiewandlungsvorrichtung 3 verbundenen Energiespeicher 32 zum Speichern von mittels der elektromechanischen Energiewandlungsvorrichtung 3 erzeugten elektrischer Energie aufweisen.

In Fig. 3 sind die optionale Steuerungseinrichtung 33 sowie der optionale elektrische Energiespeicher 32 aus Gründen der Übersichtlichkeit jeweils nicht dargestellt. Im Unterschied zur Darstellung der Fig. 2 sind in Fig. 3 jeweils der erste Endabschnitt 5a des Kraftleitfadens 5 und der zweite Endabschnitt 5b des Kraftleitfadens 5 in das piezoelektrische Material 31 eingebettet. Ein sich zwischen dem ersten und dem zweiten Endabschnitt 5a, 5b erstreckender Mittelbereich 5c erstreckt sich als Schlaufe außerhalb des piezoelektrischen Materials 31. Bei einem in das Rotorblatt 10 eingebauten Zustand ragt der Mittelbereich 5c aus dem Rotorblatt 10 heraus.

Alternativ zu dem Einbetten von zumindest einem der Endabschnitte 5a, 5b des Kraftleitfadens, wie in den Fig. 2 und 3 gezeigt, kann die mechanische Kopplung zwischen dem Kraftleitfaden 5 und dem Piezoelement 30 jeweils auch durch das Piezoelement 30 und den jeweiligen Endabschnitt 5a, 5b verbindende Verbindungsmittel realisiert werden. Beispielsweise kann der jeweilige Endabschnitt 5a, 5b mit dem Piezoelement 30 verklebt, verschweißt oder auf ähnliche Weise mit diesem verbunden werden.

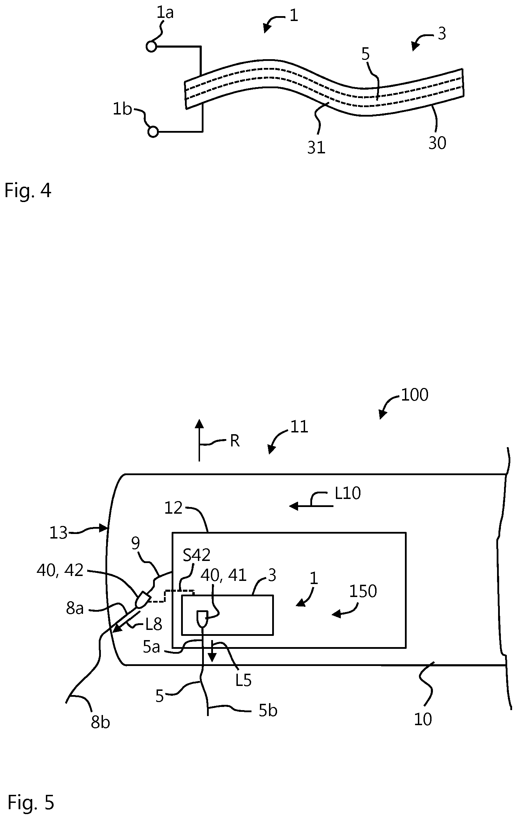

Fig. 4 zeigt beispielhaft und schematisch eine Gestaltung der elektromechanischen Energiewandlungsvorrichtung 3 als ein Piezoelement 30, welches als ein den Kraftleitfaden 5 umschließender Schlauch ausgebildet ist. In Fig. 4 umschließt das piezoelektrische Material 31 des Piezoelements 30 den Kraftleitfaden über dessen gesamte Längserstreckung. Alternativ hierzu kann vorgesehen sein, dass das piezoelektrische Material 31 lediglich einen oder mehrere Abschnitte des Kraftleitfadens 5 schlauchförmig umschließt. Durch die schlauchförmige Gestaltung des Piezoelements 30 wird eine besonders hohe Umwandlungseffizienz erzielt. Die auf diese Weise gestaltete elektromechanische Energiewandlungsvorrichtung 3 eignet sich besonders gut zur Befestigung an einer Außenoberfläche des Rotorblatts 10. Dies bietet den Vorteil, dass kaum strukturelle Änderungen des Rotorblatts 10 vorgenommen werden müssen. Dadurch kann das Energieerzeugungssystem 1 auf einfache Weise nachgerüstet werden.

Fig. 5 zeigt ein weiteres Ausführungsbeispiel des Rotorsystems 100. Dieses unterscheidet sich von dem in Fig. 1 gezeigten Rotorsystem 100 insbesondere durch den Aufbau des elektrischen Energieerzeugungssystems 1, welches bei dem in Fig. 5 gezeigten Ausführungsbeispiel als Teil eines Beleuchtungssystems 150 realisiert ist. Das elektrische Energieerzeugungssystem 1 kann, wie in den Fig. 1 und 5 gezeigt ist, in Bezug auf eine Längserstreckung L10 eines Rotorblatts 10 an dem Endabschnitt 11 desselben angeordnet sein. Das Energieerzeugungssystem 1 weist die elektromechanische Energiewandlungsvorrichtung 3 auf, die beispielsweise in der Tiefenwuchtkammer 12 in der Nähe der Rotorblattspitze 13 des Rotorblatts 10 angeordnet sein kann. Weiterhin weist das Energieerzeugungssystem 1 den zumindest einen Kraftleitfaden 5 auf, der mechanisch mit der elektromechanischen Energiewandlungsvorrichtung 3 verbunden ist.

Die elektromechanische Energiewandlungsvorrichtung 3 ist gemäß der beispielhaften Darstellung der Fig. 5 innerhalb des Querschnitts des Rotorblatts 10, nämlich in der Tiefenwuchtkammer 12, angeordnet.
Das in Fig. 5 beispielhaft gezeigte Beleuchtungssystem 150 weist das elektrische Energieerzeugungssystem 1 sowie zumindest eine an die elektromechanische Energiewandlungsvorrichtung 3 des Energieerzeugungssystems 1 elektrisch angeschlossene Lichtquelle 41, 42 auf. In dem in Fig. 5 beispielhaft gezeigten Beleuchtungssystem 150 weist sind zwei elektrischen Lichtquellen 41, 42 als elektrisch betreibbare Funktionskomponenten 40 des Rotorsystems 100 vorgesehen. Der Kraftleitfaden 5 ist mit dem ersten Fadenende 5a mechanisch mit der elektromechanischen Energiewandlungsvorrichtung 3 verbunden. Ein entgegengesetzt zu dem ersten Fadenende 5agelegenes zweites Fadenende 5b ist, wie in Fig. 5 gezeigt, außerhalb des Querschnitts des Rotorblatts 10 gelegen.

Die Lichtquellen 41, 42 sind jeweils elektrisch mit der elektromechanischen Energiewandlungsvorrichtung 3 verbunden. Vorzugsweise sind die elektrischen Lichtquellen 41, 42 jeweils innerhalb des Querschnitts des Rotorblatts 10 angeordnet, wie in Fig. 5 beispielhaft gezeigt. Insbesondere können die Lichtquellen 41, 42 als Leuchtdioden ausgebildet sein. Die Lichtquelle 41 ist in Fig. 5 beispielhaft als innerhalb der Tiefenwuchtkammer 12 angeordnet gezeigt , die Lichtquelle 42 ist gemäß der beispielhaften Darstellung der Fig. 5 außerhalb der Tiefenwuchtkammer 12 angeordnet. Selbstverständlich können auch beide Lichtquellen 41, 42 innerhalb oder außerhalb der Tiefenwuchtkammer 12 angeordnet sein.

Bei dem in Fig. 5 gezeigten Beleuchtungssystem ist an der Lichtquelle 41 ein als erste Lichtleitfaser ausgeführter Kraftleitfaden 5 befestigt. Dieser ragt in dem dargestellten Ausführungsbeispiel aus dem Rotorblatt 10 heraus und flattert daher bei Bewegung des Rotorblatts 10, beispielsweise bei einer Rotation desselben um die Rotationsachse R100 in einer Rotationsrichtung R unregelmäßig im Luftstrom. Dadurch übt der Kraftleitfaden 5 über die Lichtquelle 41 Kräfte auf die z.B. ein Piezoelement (in Fig. 5 nicht dargestellt) umfassende elektromechanische Energiewandlungsvorrichtung 3 aus. Die elektromechanische Energiewandlungsvorrichtung 3 wandelt die mechanischen Energie aus der Bewegung des Kraftleitfadens 5in elektrische Energie um, z.B. mittels der Piezoelemente, und versorgt damit die Lichtquelle 41 mit elektrischer Energie. Das von der Lichtquelle 41 in den als Lichtleitfaser ausgebildeten Kraftleitfaden 5 eingespeiste Licht wird von diesem zu dem außerhalb des Rotorblatts 10 gelegenen zweiten Fadenende 5b geleitet, tritt insbesondere am Ende des Kraftleitfadens 5 aus und erzeugt dadurch eine Signalwirkung, die eine Bewegung des Rotorblatts 10 anzeigt. Der Kraftleitfäden 5 kann insbesondere derart aus dem Rotorblatt 10 heraus geführt sein, dass dieser sich entlang dessen Fadenlängsrichtung L5 bewegen kann, wodurch eine optimale Krafteinwirkung zur Stromerzeugung auf die elektromechanische Energiewandlungsvorrichtung ausübt wird.

Die in Fig. 5 gezeigte Lichtquelle 42 ist mittels eines zusätzlichen Befestigungsfadens 9 an einer Wand der Tiefenwuchtkammer 12 befestigt. Jedoch sind auch andere Befestigungsmöglichkeiten denkbar, beispielsweise eine Befestigung der Lichtquelle 42 direkt an der Wand der Tiefenwuchtkammer 12 oder an einer anderen Stelle des Rotorblatts 10. Die für die Lichtquelle 42 benötigte elektrische Energie wird ebenfalls von der elektromechanischen Energiewandlungsvorrichtung 3 geliefert, mit der die Lichtquelle 42 elektrisch verbunden ist. Diese elektrische Verbindung ist in Fig. 5 schematisch durch die Strichpunktlinie S42 angedeutet. Der Befestigungsfaden 9 kann selbstverständlich auch mechanisch an elektromechanische Energiewandlungsvorrichtung 3 gekoppelt sein, sodass diese einen Abschnitt eines Kraftleitfadens bildet.

Wie in Fig. 5 weiterhin gezeigt, ist die Lichtquelle 42 mechanisch mit einer zweiten Lichtleitfaser 8 verbunden. Insbesondere ist die Lichtquelle 42 mechanisch derart mit der zweiten Lichtleitfaser 8 verbunden, dass die Lichtquelle 42 Licht in diese einleitet. Hierzu ist die Lichtquelle 8 mit einem ersten Endabschnitt 8a der zweiten Lichtleitfaser 8 verbunden. Die zweite Lichtleitfaser 8 ragt mit einem in Bezug auf die Längserstreckung oder die Fadenlängsrichtung L8 der Lichtleitfaser 8 entgegengesetzt zu dem ersten Endabschnitt 8a gelegenen zweiten Endabschnitt 8b aus dem Rotorblatt 10, bevorzugt direkt aus dessen Rotorblattspitze 13, heraus. Bei einer Herausführung der zweiten Lichtleitfaser 8 direkt an der Rotorblattspitze 13 wird eine gute Signal- und Warnwirkung direkt an der Rotorblattspitze 13, ergänzend zu dem von der ersten Lichtleitfaser 5 ausgestrahlten Licht erzielt. Die an der Rotorblattspitze 13 austretende Lichtleitfaser 8 zeigt damit die äußere Begrenzung der Rotorblattbewegung an.

Wie bereits beschrieben, kann auch vorgesehen sein, dass der Befestigungsfaden 9 mechanisch mit der elektromechanischen Energiewandlungsvorrichtung 3 verbunden ist. In diesem Fall bilden die zweite Lichtleitfaser 8 und der Befestigungsfaden 9 jeweils einen Abschnitt eines Kraftleitfadens 5 aus.

### Bezugszeichenliste

- 1: elektrisches Energieerzeugungssystem
- 1a, 1b: elektrische Anschlussstellen
- 3: elektromechanische Energiewandlungsvorrichtung
- 4: elektrische Versorgungsleitung
- 5: Kraftleitfaden
- 5a: erstes Fadenende des Kraftleitfadens
- 5b: zweites Fadenende des Kraftleitfadens
- 5c: Mittelbereich des Kraftleitfadens
- 8: Lichtleitfaser
- 8a: erster Endabschnitt der Lichtleitfaser
- 8b: zweiter Endabschnitt der Lichtleitfaser
- 9: Befestigungsfaden
- 10: Rotorblatt
- 11: Endabschnitt des Rotorblatts
- 12: Tiefenwuchtkammer
- 13: Rotorblattspitze
- 30: Piezoelement
- 31: piezoelektrisches Material
- 32: Energiespeicher
- 33: Steuerungseinrichtung
- 40: Funktionskomponente
- 41: erste Lichtquelle
- 42: zweite Lichtquelle
- 43: Sensor
- 44: Aktuatoreinrichtung
- 100: Rotorsystem
- 101: Rotorschaft
- 102: Taumelscheibe
- 103: Aktuatorstab
- 150: Beleuchtungssystem
- 200: Luftfahrzeug
- 201: Rumpfstruktur
- L5: Fadenlängsrichtung des Kraftleitfadens
- L8: Fadenlängsrichtung der Lichtleitfaser
- L10: Längserstreckung des Rotorblatts
- R: Rotationsrichtung
- R100: Rotationsachse
- S42: Strichpunktlinie

## Patentansprüche

1. Rotorblatt (10) für ein Luftfahrzeug mit einem elektrischen Energieerzeugungssystem (1), welches aufweist:
zumindest eine elektromechanische Energiewandlungsvorrichtung (3); und
zumindest einen Kraftleitfaden (5), der mit der elektromechanischen Energiewandlungsvorrichtung (3) mechanisch verbunden ist und zumindest abschnittsweise außerhalb des Rotorblatts (10) verläuft;
wobei die elektromechanische Energiewandlungsvorrichtung (3) derart gestaltet ist, dass diese bei einer Bewegung des Kraftleitfadens (5) die durch die Bewegung des Kraftleitfadens (5) in die elektromechanische Energiewandlungsvorrichtung (3) eingeleiteten Kräfte in elektrische Energie umwandelt.

2. Rotorblatt (10) nach Anspruch 1, wobei die elektromechanische Energiewandlungsvorrichtung (3) zumindest ein mechanisch mit dem Kraftleitfaden (5) verbundenes Piezoelement (30) zur Umwandlung mechanischer Energie aus der Bewegung des Kraftleitfadens (5) in elektrische Energie aufweist.

3. Rotorblatt (10) nach Anspruch 2, wobei der Kraftleitfaden zumindest abschnittsweise von einem piezoelektrischen Material (31) des Piezoelements (30) umgeben ist.

4. Rotorblatt (10) nach einem der voranstehenden Ansprüche, wobei das elektrische Energieerzeugungssystem (1) zusätzlich aufweist:
zumindest einen elektrisch mit der elektromechanischen Energiewandlungsvorrichtung (3) verbundenen Energiespeicher (32) zum Speichern elektrischer Energie.

5. Rotorblatt (10) nach einem der voranstehenden Ansprüche, wobei das elektrische Energieerzeugungssystem (1) zusätzlich aufweist:
eine elektronische Steuerungseinrichtung (33), mittels derer eine Bereitstellung von mittels der elektromechanischen Energiewandlungsvorrichtung (3) erzeugter elektrischer Spannung an zum Anschluss elektrischer Funktionskomponenten vorgesehenen elektrischen Anschlussstellen (1a; 1b) des Energieerzeugungssystems (1) ein- oder ausschaltbar ist.

6. Rotorblatt (10) nach Anspruch 5, wobei die Steuerungseinrichtung (33) des elektrische Energieerzeugungssystems (1) drahtlos ansteuerbar ist.

7. Rotorblatt (10) nach einem der voranstehenden Ansprüche, zusätzlich aufweisend:
ein Beleuchtungssystem (150) mit wenigstens einer elektrischen Lichtquelle (41, 42), die mit der Energiewandlungsvorrichtung (3) des elektrischen Energieerzeugungssystems (1) elektrisch verbunden ist.

8. Rotorblatt (10) nach Anspruch 7, wobei der Kraftleitfaden (5) des Energieerzeugungssystems (1) als lichtleitende Faser ausgebildet ist und der Kraftleitfaden (5) mit der Lichtquelle (41; 42) mechanisch derart verbunden ist, dass die Lichtquelle (41; 42) Licht in den Kraftleitfaden (5) einleitet, und die Lichtquelle (41; 42) mit der elektromechanischen Energiewandlungsvorrichtung (3) mechanisch derart verbunden ist, dass die durch die Bewegung des Kraftleitfadens (5) erzeugten Kräfte über die Lichtquelle (4, 7) zu der elektromechanischen Energiewandlungsvorrichtung (3) übertragen werden.

9. Rotorblatt (10) nach Anspruch 7 oder 8, wobei die wenigstens eine Lichtquelle (41; 42) jeweils zumindest eine Leuchtdiode aufweist.

10. Rotorblatt (10) nach einem der Ansprüche 7 bis 9, wobei die Lichtquelle (41; 42) im Inneren des Rotorblatts (10) angeordnet ist.

11. Rotorblatt (10) nach Anspruch 10, wobei die Lichtquelle (41; 42) in einer Tiefenwuchtkammer (12) des Rotorblatts (10), angeordnet ist.

12. Rotorblatt (10) nach einem der voranstehenden Ansprüche, wobei die elektromechanische Energiewandlungsvorrichtung (3) im Inneren des Rotorblatts (10), insbesondere in einer Tiefenwuchtkammer (12) des Rotorblatts (10), angeordnet ist.

13. Rotorsystem (100) für ein Luftfahrzeug, mit:
zumindest einem Rotorblatt (10) nach einem der voranstehenden Ansprüche; und
zumindest einer elektrisch betreibbaren Funktionskomponente (40), welche elektrisch mit der Energiewandlungsvorrichtung (3) des elektrischen Energieerzeugungssystems (1) verbunden ist.

14. Rotorsystem (100) nach Anspruch 13, wobei die elektrisch betreibbare Funktionskomponente (40) als ein Sensor (43), eine Aktuatoreinrichtung (44) oder dergleichen ausgebildet ist.

## Claims

1. Rotor blade (10) for an aircraft with an electrical energy generating system (1), which has:
at least one electromechanical energy converting device (3); and
at least one force-conducting line (5), which is mechanically connected to the electromechanical energy converting device (3) and runs at least in some sections outside the rotor blade (10);
the electromechanical energy converting device (3) being designed in such a way that, when there is a movement of the force-conducting line (5), it converts the forces introduced into the electromechanical energy converting device (3) by the movement of the force-conducting line (5) into electrical energy.

2. Rotor blade (10) according to Claim 1, the electromechanical energy converting device (3) having at least one piezo element (30), mechanically connected to the force-conducting line (5), for converting mechanical energy from the movement of the force-conducting line (5) into electrical energy.

3. Rotor blade (10) according to Claim 2, the force-conducting line being surrounded at least in some sections by a piezoelectric material (31) of the piezo element (30).

4. Rotor blade (10) according to one of the preceding claims, the electrical energy generating system (1) additionally having:
at least one energy store (32), electrically connected to the electromechanical energy converting device (3), for storing electrical energy.

5. Rotor blade (10) according to one of the preceding claims, the electrical energy generating system (1) additionally having:
an electronic control device (33), by means of which a supply of electrical voltage generated by means of the electromechanical energy converting device (3) can be switched on or off at electrical connection points (1a; 1b) of the energy generating system (1) that are provided for the connection of electrical functional components.

6. Rotor blade (10) according to Claim 5, the control device (33) of the electrical energy generating system (1) being wirelessly activatable.

7. Rotor blade (10) according to one of the preceding claims, additionally having:
an illumination system (150) with at least one electrical light source (41, 42), which is electrically connected to the energy converting device (3) of the electrical energy generating system (1).

8. Rotor blade (10) according to Claim 7, the force-conducting line (5) of the energy generating system (1) being formed as a light-conducting fibre and the force-conducting line (5) being mechanically connected to the light source (41; 42) in such a way that the light source (41; 42) introduces light into the force-conducting line (5), and the light source (41; 42) being mechanically connected to the electromechanical energy converting device (3) in such a way that the forces generated by the movement of the force-conducting line (5) are transmitted via the light source (4, 7) to the electromechanical energy converting device (3).

9. Rotor blade (10) according to Claim 7 or 8, the at least one light source (41; 42) having in each case at least one light-emitting diode.

10. Rotor blade (10) according to one of Claims 7 to 9, the light source (41; 42) being arranged in the interior of the rotor blade (10).

11. Rotor blade (10) according to Claim 10, the light source (41; 42) being arranged in a depth-balancing chamber (12) of the rotor blade (10).

12. Rotor blade (10) according to one of the preceding claims, the electromechanical energy converting device (3) being arranged in the interior of the rotor blade (10), in particular in a depth-balancing chamber (12) of the rotor blade (10).

13. Rotor system (100) for an aircraft, with:
at least one rotor blade (10) according to one of the preceding claims; and
at least one electrically operable functional component (40), which is electrically connected to the energy converting device (3) of the electrical energy generating system (1).

14. Rotor system (100) according to Claim 13, the electrically operable functional component (40) being formed as a sensor (43), an actuator device (44) or the like.

## Revendications

1. Pale de rotor (10) pour un aéronef comprenant un système de génération d'énergie électrique (1), qui possède :
au moins un dispositif de conversion d'énergie électromécanique (3) ;
et
au moins un fil conducteur de force (5), lequel est relié mécaniquement au dispositif de conversion d'énergie électromécanique (3) et s'étend au moins par certaines portions à l'extérieur de la pale de rotor (10) ;
le dispositif de conversion d'énergie électromécanique (3) étant configuré de telle sorte que lors d'un mouvement du fil conducteur de force (5), celui-ci convertit en énergie électrique les forces induites dans le dispositif de conversion d'énergie électromécanique (3) par le mouvement du fil conducteur de force (5).

2. Pale de rotor (10) selon la revendication 1, le dispositif de conversion d'énergie électromécanique (3) possédant au moins un élément piézoélectrique (30) relié mécaniquement au fil conducteur de force (5) et servant à convertir en énergie électrique l'énergie mécanique résultant du mouvement du fil conducteur de force (5).

3. Pale de rotor (10) selon la revendication 2, le fil conducteur de force étant entouré au moins dans certaines portions par un matériau piézoélectrique (31) de l'élément piézoélectrique (30).

4. Pale de rotor (10) selon l'une des revendications précédentes, le système de génération d'énergie électrique (1) possédant en outre :
au moins un accumulateur d'énergie (32) destiné à accumuler de l'énergie électrique et relié électriquement au dispositif de conversion d'énergie électromécanique (3).

5. Pale de rotor (10) selon l'une des revendications précédentes, le système de génération d'énergie électrique (1) possédant en outre :
un dispositif de commande électronique (33) au moyen duquel peut être mise en ou hors circuit une fourniture de la tension électrique générée au moyen du dispositif de conversion d'énergie électromécanique (3) à des points de raccordement (1a ; 1b) du système de génération d'énergie (1), conçus pour le raccordement de composants fonctionnels électriques.

6. Pale de rotor (10) selon la revendication 5, le dispositif de commande (33) du système de génération d'énergie électrique (1) pouvant être piloté sans fil.

7. Pale de rotor (10) selon l'une des revendications précédentes, possédant en outre :
un système d'éclairage (150) comprenant au moins une source de lumière (41, 42) électrique qui est reliée électriquement au dispositif de conversion d'énergie (3) du système de génération d'énergie électrique (1).

8. Pale de rotor (10) selon la revendication 7, le fil conducteur de force (5) du système de génération d'énergie (1) étant réalisé sous la forme d'une fibre optique et le fil conducteur de force (5) étant relié mécaniquement à la source de lumière (41 ; 42) de telle sorte que la source de lumière (41 ; 42) injecte de la lumière dans le fil conducteur de force (5), et la source de lumière (41 ; 42) étant reliée mécaniquement au dispositif de conversion d'énergie électromécanique (3) de telle sorte que les forces produites par le mouvement du fil conducteur de force (5) sont transmises au dispositif de conversion d'énergie électromécanique (3) par le biais de la source de lumière (4, 7).

9. Pale de rotor (10) selon la revendication 7 ou 8, l'au moins une source de lumière (41 ; 42) possédant respectivement au moins une diode électroluminescente.

10. Pale de rotor (10) selon l'une des revendications 7 à 9, la source de lumière (41 ; 42) étant disposée à l'intérieur de la pale de rotor (10).

11. Pale de rotor (10) selon la revendication 10, la source de lumière (41 ; 42) étant disposée dans une chambre d'équilibrage en profondeur (12) de la pale de rotor (10).

12. Pale de rotor (10) selon l'une des revendications précédentes, le dispositif de conversion d'énergie électromécanique (3) étant disposé à l'intérieur de la pale de rotor (10), notamment dans une chambre d'équilibrage en profondeur (12) de la pale de rotor (10).

13. Système de rotor (100) pour un aéronef, comprenant :
au moins une pale de rotor (10) selon l'une des revendications précédentes ; et
au moins un composant fonctionnel (40) qui peut fonctionner à l'électricité, lequel est relié électriquement au dispositif de conversion d'énergie (3) du système de génération d'énergie électrique (1).

14. Système de rotor (100) selon la revendication 13, le composant fonctionnel (40) qui peut fonctionner à l'électricité étant réalisé sous la forme d'un capteur (43), d'un dispositif actionneur (44) ou similaire.
